# EUROPÄISCHE PATENTSCHRIFT

(11) **EP 2 089 969 B1**
(45) Veröffentlichungstag und Bekanntmachung des Hinweises auf die Patenterteilung: **10.07.2013**
(21) Anmeldenummer: 07723225.4
(22) Anmeldetag: 13.03.2007
(51) Int. Cl.: H03K 17/955

(54) **KAPAZITIVE SENSOREINRICHTUNG**
CAPACITIVE SENSOR DEVICE
SYSTÈME CAPACITIF DE DÉTECTION

(30) Priorität: 13.03.2006 DE 102006011825
(43) Veröffentlichungstag der Anmeldung: 19.08.2009
(73) Patentinhaber: IDENT Technology AG, 82205 Gilching (DE)
(72) Erfinder: KALTNER, Klaus, 85232 Bergkirchern (DE)
(74) Vertreter: Grubert, Andreas
(86) Internationale Anmeldenummer: PCT/EP2007/002215
(87) Internationale Veröffentlichungsnummer: WO 2007/104540

(56) Entgegenhaltungen:
- WO-A-98/07051
- DE-A1- 4 006 119
- GB-A- 2 404 443

## Beschreibung

Die Erfindung bezieht sich auf eine Anordnung zur Generierung eines hinsichtlich seiner räumlichen Ausbreitung markant beeinflussten elektrischen Feldes, sowie auch auf eine unter Einschluss derselben gebildete Sensoreinrichtung.

Der Erfindung liegt die Aufgabe zugrunde, Lösungen zu schaffen durch welche es möglich wird, ein an sich quasistatisches elektrisches Wechselfeld zu generieren das sich mit einer gewissen Fokussierung, in einen als Überwachungs- oder Signal-übertragungsbereich relevanten Präferenzbereich hinein ausbreitet.

Diese Aufgabe wird erfindungsgemäß gelöst durch eine Schaltungsanordnung mit:
- einer Feldbereitungselektrodeneinrichtung die als solche in ein LC-Netzwerk eingebunden ist, und die derart zu einem Feldraumbereich hin freiliegt, dass sich die Kapazität eines unter Einschluss der Elektrodeneinrichtung gebildeten Kondensatorsystems in Abhängigkeit von den dielektrischen Eigenschaften der in dem Feldraumbereich vorhandenen Materie ändert,
- einer Isolatorlage die sich auf einer dem Feldraumbereich abgewandten Rückseite der Feldelektrodeneinrichtung erstreckt,
- einer Abschirmelektrodeneinrichtung die sich auf einer der FeldElektrodeneinrichtung abgewandten Rückseite der Isolatorlage erstreckt, und
- einer Feldextinktionselektrodeneinrichtung die als solche eine, einem Extinktionsbereich zugewandte Elektrodenfläche aufweist, wobei die Feldbereitungselektrodeneinrichtung und die Feldextinktionselektrodeneinrichtung derart angeordnet und spannungsbeaufschlagt sind, dass der Feldraumbereich und der Extinktionsbereich einander abschnittsweise überlagern.

Dadurch wird es auf vorteilhafte Weise möglich, den seitlich ausfließenden Randbereich des durch die Feldbereitungselektrode generierten Feldes zu kappen und den über die Feldbereitungselektrode observierten Raumbereich relativ scharf zu begrenzen.

Vorzugsweise ist die Feldextinktionselektrodeneinrichtung derart angeordnet und angeschaltet, dass durch diese eine Randzone des in den Feldraumbereich eindringenden Feldes der Feldbereitungselektrodeneinrichtung beschnitten wird.

Zwischen der Feldbereitungselektrodeneinrichtung und der Feldextinktionselektrodeneinrichtung ist vorzugsweise eine Trennelektrodeneinrichtung vorgesehen ist. Diese Trennelektrodeneinrichtung ist vorzugsweise zwischen zwei Isolatormateriallagen aufgenommen und mit der Abschirmelektrodeneinrichtung gekoppelt. Die Trennelektrodeneinrichtung kann mit der Abschirmelektrodeneinrichtung direkt leitend gekoppelt sein, insbesondere integral mit diese ausgebildet sein.

An die Feldextinktionselektrodeneinrichtung wird erfindungsgemäß eine Spannung mit einem in Bezug zur Spannung an der Feldbereitungselektrodeneinrichtung phasenversetzten Verlauf angelegt. Der Phasenversatz beträgt vorzugsweise im wesentlichen π und die Spannung liegt vorzugsweise in der Größenordnung der Spannung an der Feldbereitungselektrodeneinrichtung. Es ist möglich, die Schaltung so aufzubauen, dass der Phasenversatz und der Spannungsabstand einstellbar veränderbar sind.

Die Trennelektrodeneinrichtung kann so ausgebildet sein, dass diese stegartig zwischen der Feldbereitungselektrode und der Feldextinktionselektrode verläuft. Die Trennelektrodeneinrichtung kann insbesondere integral mit der Abschirmelektrodeneinrichtung ausgebildet sein.

Durch das erfindungsgemäße Konzept wird es möglich, relativ niederfrequent betriebene kapazitive Sensoren mit ausgeprägter Richtwirkung zu realisieren. Die Erfindung ermöglicht es, kapazitive Sensoren durch eine geeignete Sensor-Struktur und eine geeignete Elektronik mit einer Richtcharakteristik zu versehen.

Die Feldbereitungselektrodeneinrichtung bildet Bestandteil eines Oszillators, dessen frequenzbestimmende Kapazität von den dielektrischen Eigenschaften der Umgebung der Feldbereitungselektrodeneinrichtung abhängig ist. Nähert sich ein Körper der Feldbereitungselektrodeneinrichtung, so erhöht sich die Kapazität und damit verändert sich die Frequenz. Damit Masseflächen nicht die Empfindlichkeit des Systems reduzieren, wird die Massefläche durch ein mit dem Sensor gleichphasiges Signal gleicher Spannung ausgeblendet. (Transimpedanzwandler als Shield-Treiber)

Weitere Einzelheiten und Merkmale der Erfindung ergeben sich aus der nachfolgenden Beschreibung in Verbindung mit der Zeichnung. Es zeigt:
- **Figur 1**: ein Prinzipschaltbild eines auf der Nutzung feldelektrischer Wechselwirkungseffekte basierenden Sensorsystems;
- **Figur 2**: eine Prinzipskizze zur Veranschaulichung der Empfindlichkeitsverteilung bei einem flächig aufgebauten Sensor ohne Shield;
- **Figur 3**: eine Prinzipskizze zur Veranschaulichung der Empfindlichkeitsverteilung bei einem flächig aufgebauten Sensor mit Shield;
- **Figur 4**: eine Prinzipskizze zur Veranschaulichung eines mit einer Feldextinktionselektrodeneinrichtung und einer Abschirmstegelektrode versehenen Cutted-Field Sensors;
- **Figur 5**: eine Prinzipskizze zur Veranschaulichung der Anschaltung der Elektroden des Sensors nach Figur 4 für gegenphasige Spannungsbeaufschlagung der Feldextinktionselektrode; (Cutted-Field Betriebsmodus)
- **Figur 6**: eine Prinzipskizze zur Veranschaulichung der Anschaltung der Elektroden des Sensors nach Figur 4 für gleichphasige Spannungsbeaufschlagung der Feldextinktionselektrode (Wide-Field Betriebsmodus).

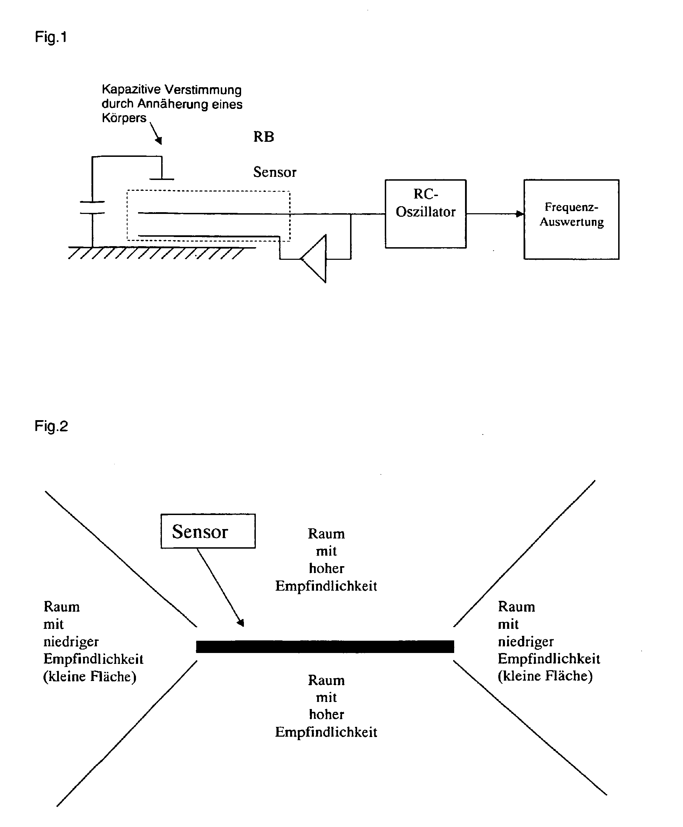

Figur 1 zeigt ein Prinzipschaltbild eines auf der Nutzung feldelektrischer Wechselwirkungseffekte basierenden Sensorsystems. Über dieses Sensorsystems kann ein der Feldbereitungselektrode 1 vorgelagerter Raumbereich RB observiert werden. Dies erfolgt indem die Feldbereitungselektrode 1 Bestandteil eines LC-Netzwerkes bildet. Die Feldbereitungselektrode 1 bildet hierbei insbesondere Teil einer für das LC-Netzwerk frequenzbestimmenden Kapazität. Diese Kapazität wird durch Änderungen der dielektrischen Eigenschaften der Materie im Raumbereich RB beeinflusst.

In Figur 2 ist dargestellt, welche Zonen des die Feldbereitungselektrodeneinrichtung 1 umgebenden Raumbereiches für die Kapazität des unter Einschluss der Feldbereitungselektrodeneinrichtung gebildeten Kondensatorsystems haben. Wie erkennbar sind die den an die Hauptflächen der Feldbereitungselektrodeneinrichtung angrenzenden Raumsegmente für die Kapazität in einem höheren Ausmaß prägend, als die randseitig zwischen den genannten Raumsegmenten umlaufenden Randraumzwickel.

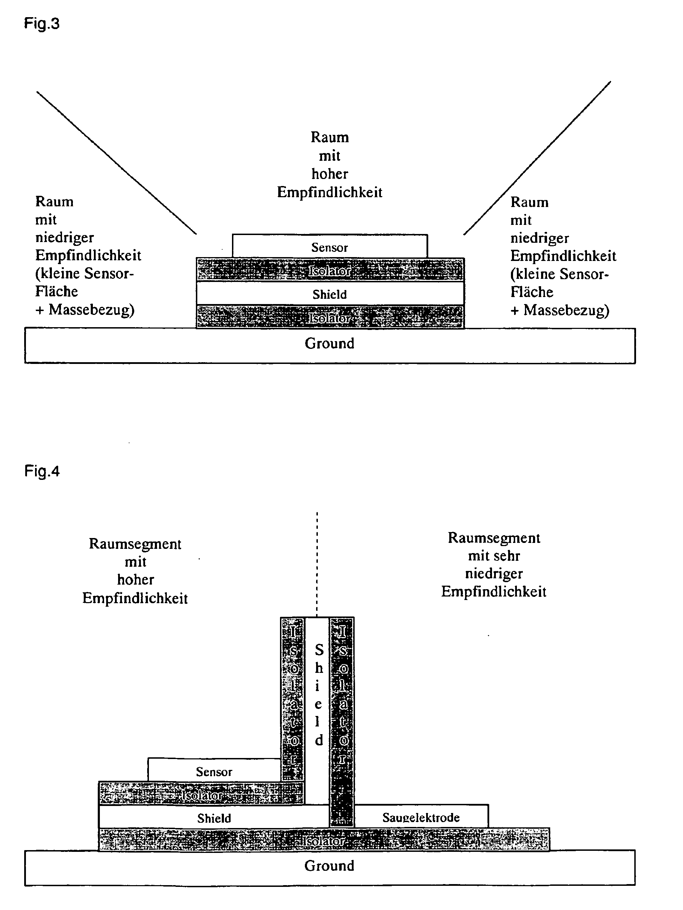

In Figur 3 ist eine einseitig abgeschirmte Anordnung einer Feldbereitungselektrodeneinrichtung dargestellt. Bei dem Ausführungsbeispiel nach Figur 3 ist es so, dass die Frequenzänderung eines Körpers an die Feldbereitungselektrode 1 die Frequenzänderung umso größer ist, je mehr Elektrodenfläche jenem sich annäherenden Körper gegenübersteht.

Das nachfolgend insbesondere in Verbindung mit Figur 4 beschriebene Konzept macht es möglich, bereits mit relativ niederfrequenten (quasi statisch betriebenen) Sensoren im Nahfeld eine gute Richtwirkung zu erzielen. Durch das erfindungsgemäße Konzept wird es möglich, den Raum vor dem Sensor aufzuteilen und ein Raumsegment auszublenden. Es entsteht dabei eine Richtcharakteristik, die für niederfrequent betriebene kapazitive Sensoren untypisch ausgeprägt ist. Durch das erfindungemäße Konzept wird es auf vorteilhafte Weise möglich, in relativ markant begrenzten einem Raumsegment auf Bewegungen zu reagieren (Detektieren, Schalten, Regeln, etc.) und die Bewegungen in einem anderen Raumsegment zu ignorieren.

Es sind erfindungsgemäß Elektroden vorgesehen, deren Wirkung es ist, das elektrische Sensor-Feld in einem gewünschten Raum effektiv zu neutralisieren bzw. 'abzusaugen'. Im weiteren wird deshalb von 'Saugelektroden' gesprochen. Figur 4 zeigt den prinzipiellen Sensor-Aufbau. Die Elektrodenanordnung kann dabei auch variiert werden. Es kann beispielsweise der Sensor auch oder zusätzlich in die Vertikale gezogen werden um eine erhöhte Empfindlichkeit in x-Richtung zu erlangen.

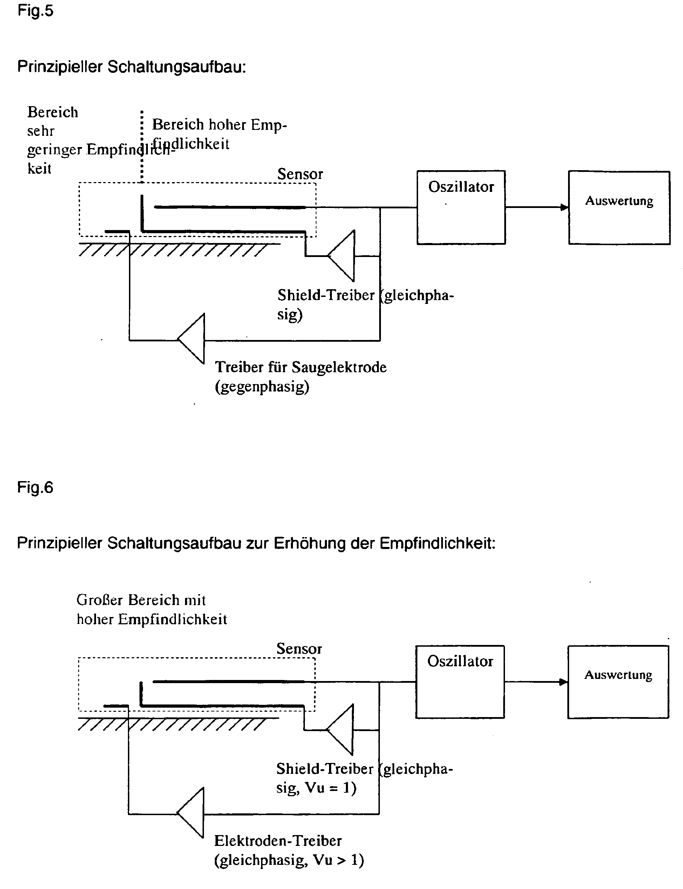

Figur 5 veranschaulicht den prinzipiellen Aufbau der erfindungsgemäßen Schaltung s. Um eine gute Feldneutralisation im unerwünschten Raumsegment zu erreichen, wird die Saugelektrode gegenüber der Sensor-Elektrode gegenphasig angesteuert.

Die Erfindung kann mit besonderem Vorteil dort eingesetzt werden, wo eine ausgeprägte Richtwirkung notwendig ist. Dies ist z.B. bei Ersatz von Lichtschranken oder Lichtgittern der Fall oder bei einem Einklemmschutz, bei dem ganz gezielt nur der gefährdete Bereich detektiert wird. Sie eignet sich auch für eine Aneinander-Reihung von Kapazitiven Schalter auf engstem Raum.

Es ist möglich, die jeweilige Sensorschaltung, adressierbar ansteuerbar zu gestalten. Es ist auch möglich, deren Funktionsweise phasenweise zu variieren. So kann beispielsweise für eine bestimmte Anzahl oder Zeitdauer von Wechselzyklen des Detektionsfeldes auch die Art der Begrenzung des Detektionsfeldes - vorzugsweise adressiert angesteuert - verändert werden. Hierdurch wird eine Kombinierte Überwachung des umfassenden Observationsbereiches und eine Unterscheidung zwischen der Präsenz eines Objektes im gekappten, oder im großen Bereich möglich. Es ist grundsätzlich auch möglich, schaltungstechnische Maßnahmen zu treffen die es ermöglichen ausgewählte Elektroden wechselweise als Feldbereitungs- und als Feldextinktionselektroden zu verwenden.

Wie aus Figur 6 ersichtlich, kann zur Erhöhung der Empfindlichkeit die Ground-Kapazität reduziert/kompensiert werden. Dies ist durch Verwendung der Sensor-Geometrie (Sensor + Shield) möglich, wenn Ground-Flächen über den Sensor hinaus mit einer Shield-Elektrode kompensiert werden. Auf kleinerem Raum ist die Erhöhung der Empfindlichkeit möglich, wenn eine weitere Elektrode zugefügt wird, die mit einer gleichphasig, höheren Spannung als der Sensor betrieben wird. Die Spannungsverstärkung Vu des Treibers muss also größer als eins sein. Dies ist auch in Kombination mit einer Saugelektrode möglich. Die Auswertung der kapazitiven Änderung kann mit allen üblichen Auswerteverfahren erfolgen, wie z.B. Frequenzverfahren, Phasenverfahren, Amplitudenverfahren.

## Patentansprüche

1. Schaltungsanordnung mit:
- einer Feldbereitungselektrodeneinrichtung die als solche in ein LC-Netzwerk eingebunden ist, und die derart zu einem Feldraumbereich hin freiliegt, dass sich die Kapazität eines unter Einschluss der Feldbereitungselektrodeneinrichtung gebildeten Kondensatorsystems in Abhängigkeit von den dielektrischen Eigenschaften der in dem Feldraumbereich vorhandenen Materie ändert,
- einer Isolatorlage die sich auf einer dem Feldraumbereich abgewandten Rückseite der Feldbereitungselektrodeneinrichtung erstreckt,
- einer Abschirmelektrodeneinrichtung die sich auf einer der Feldbereitungs: Elektrodeneinrichtung abgewandten Rückseite der Isolatorlage erstreckt, und
- einer Feldextinktionselektrodeneinrichtung die als solche eine, einem Extinktionsbereich zugewandte Elektrodenfläche aufweist,
- wobei die Feldbereitungselektrodeneinrichtung und die Feldextinktionselektrodeneinrichtung derart angeordnet und spannungsbeaufschlagt sind, dass der Feldraumbereich und der Extinktionsbereich einander abschnittsweise überlagern.

2. Schaltungsanordnung nach Anspruch 1, **dadurch gekennzeichnet, dass** die Feldextinktionselektrodeneinrichtung derart angeordnet und angeschaltet ist, dass durch diese eine Randzone des in den Feldraumbereich eindringenden Feldes der Feldbereitungselektrodeneinrichtung beschnitten wird.

3. Schaltungsanordnung nach Anspruch 1 oder 2, **dadurch gekennzeichnet, dass** zwischen der Feldbereitungselektrodeneinrichtung und der Feldextinktionselektrodeneinrichtung eine Trennelektrodeneinrichtung vorgesehen ist.

4. Schaltungsanordnung nach wenigstens einem der Ansprüche 1 bis 3, **dadurch gekennzeichnet, dass** die Trennelektrodeneinrichtung zwischen zwei Isolatormateriallagen aufgenommen ist.

5. Schaltungsanordnung nach wenigstens einem der Ansprüche 1 bis 4, **dadurch gekennzeichnet, dass** die Trennelektrodeneinrichtung mit der Abschirmelektrodeneinrichtung gekoppelt ist.

6. Schaltungsanordnung nach wenigstens einem der Ansprüche 1 bis 5, **dadurch gekennzeichnet, dass** die Trennelektrodeneinrichtung mit der Abschirmelektrodeneinrichtung direkt leitend gekoppelt ist.

7. Schaltungsanordnung nach wenigstens einem der Ansprüche 1 bis 6, **dadurch gekennzeichnet, dass** an die Feldextinktionselektrodeneinrichtung eine Spannung mit einem in Bezug zur Spannung an der Feldbereitungselektrodeneinrichtung phasenversetzten Verlauf angelegt wird.

8. Schaltungsanordnung nach wenigstens einem der Ansprüche 1 bis 7, **dadurch gekennzeichnet, dass** der Phasenversatz im wesentlichen π beträgt und die Spannung in der Größenordnung der Spannung an der Feldbereitungselektrodeneinrichtung liegt.

9. Schaltungsanordnung nach wenigstens einem der Ansprüche 1 bis 8, **dadurch gekennzeichnet, dass** der Phasenversatz einstellbar veränderbar ist.

10. Schaltungsanordnung nach wenigstens einem der Ansprüche 1 bis 9, **dadurch gekennzeichnet, dass** der Spannungsabstand zwischen der Feldbereitungselektrode und der Feldextinktionselektrode einstellbar veränderbar ist.

11. Schaltungsanordnung nach wenigstens einem der Ansprüche 1 bis 10, **dadurch gekennzeichnet, dass** die Trennelektrodeneinrichtung stegartig zwischen der Feldbereitungselektrode und der Feldextinktionselektrode verläuft.

## Claims

1. A circuit arrangement, comprising:
- a field preparation electrode device, which as such is integrated in a LC network and is exposed to a field range area such that the capacity of a capacitor system formed with the inclusion of the field preparation electrode device changes depending on the dielectric properties of the material existing in the field range area,
- an isolating layer extending on a backside of the field preparation electrode device averted from the field range area,
- a shielding electrode device extending on a backside of the isolating layer averted from the field preparation electrode device, and
- a field extinction electrode device, which as such comprises an electrode surface facing an extinction area,
- wherein the field preparation electrode device and the field extinction electrode device are arranged and voltage loaded such that the field range area and the extinction area overlay each other in sections.

2. The circuit arrangement of claim 1, **characterized in that** the field extinction electrode device is arranged and activated such that thereby an edge zone of the field of the field preparation electrode device penetrating the field range area is trimmed.

3. The circuit arrangement of claim 1 or 2, **characterized in that** a separation electrode device is provided between the field preparation electrode device and the field extinction electrode device.

4. The circuit arrangement of at least one of claims 1 to 3, **characterized in that** the separation electrode device is incorporated between two isolating material layers.

5. The circuit arrangement of at least one of claims 1 to 4, **characterized in that** the separation electrode device is coupled with the shielding electrode device.

6. The circuit arrangement of at least one of claims 1 to 5, **characterized in that** the separation electrode device is coupled with the shielding electrode device in a directly conducting manner.

7. The circuit arrangement of at least one of claims 1 to 6, **characterized in that** a voltage comprising a phase-shifted time curve with respect to the voltage at the field preparation electrode device is applied to the field extinction electrode device.

8. The circuit arrangement of at least one of claims 1 to 7, **characterized in that** the phase shift substantially is π and the voltage is of the magnitude of the voltage at the field preparation electrode device.

9. The circuit arrangement of at least one of claims 1 to 8, **characterized in that** the phase shift may be modified in an adjustable manner.

10. The circuit arrangement of at least one of claims 1 to 9, **characterized in that** the voltage difference between the field preparation electrode and the field extinction electrode may be modified in an adjustable manner.

11. The circuit arrangement of at least one of claims 1 to 10, **characterized in that** the separation electrode device runs between the field preparation electrode and the field extinction electrode in the form of a separator strip.

## Revendications

1. Agencement de circuit, comportant :
- un dispositif à électrode de préparation de champ qui, en tant que tel, est intégré dans un réseau LC et qui est dégagé par rapport à une zone de champ, de telle sorte que la capacité d'un système de condensateur, formé en incluant le dispositif à électrode de préparation de champ, varie en fonction des propriétés diélectriques de la matière présente dans la zone de champ,
- une couche isolante qui s'étend sur une face arrière du dispositif à électrode de préparation de champ, détournée de la zone de champ,
- un dispositif à électrode de protection qui s'étend sur une face arrière de la couche isolante, détournée du dispositif à électrode de préparation de champ, et
- un dispositif à électrode d'extinction de champ qui, en tant que tel, présente une surface d'électrode orientée vers une zone d'extinction,
- le dispositif à électrode de préparation de champ et le dispositif à électrode d'extinction de champ sont agencés et alimentés en tension de telle sorte que la zone de champ et la zone d'extinction se superposent l'une l'autre par segments.

2. Agencement de circuit selon la revendication 1, **caractérisé en ce que** le dispositif à électrode d'extinction de champ est agencé et connecté de telle sorte que celui-ci coupe une zone de bordure du champ du dispositif à électrode de préparation de champ, pénétrant dans la zone de champ.

3. Agencement de circuit selon la revendication 1 ou 2, **caractérisé en ce qu'**un dispositif à électrode de séparation est prévu entre le dispositif à électrode de préparation de champ et le dispositif à électrode d'extinction de champ.

4. Agencement de circuit selon au moins l'une quelconque des revendications 1 à 3, **caractérisé en ce que** le dispositif à électrode de séparation est logé entre deux couches de matériaux isolants.

5. Agencement de circuit selon au moins l'une quelconque des revendications 1 à 4, **caractérisé en ce que** le dispositif à électrode de séparation est couplé au dispositif à électrode de protection.

6. Agencement de circuit selon au moins l'une quelconque des revendications 1 à 5, **caractérisé en ce que** le dispositif à électrode de séparation est couplé de manière directement conductrice au dispositif à électrode de protection.

7. Agencement de circuit selon au moins l'une quelconque des revendications 1 à 6, **caractérisé en ce qu'**une tension avec un tracé décalé en phases par rapport à la tension appliquée sur le dispositif à électrode de préparation de champ est appliquée sur le dispositif à électrode d'extinction de champ.

8. Agencement de circuit selon au moins l'une quelconque des revendications 1 à 7, **caractérisé en ce que** le décalage de phases est sensiblement de l'ordre de π et la tension est de l'ordre de grandeur de la tension appliquée sur le dispositif à électrode de préparation de champ.

9. Agencement de circuit selon au moins l'une quelconque des revendications 1 à 8, **caractérisé en ce que** le décalage de phases peut être réglé de manière variable.

10. Agencement de circuit selon au moins l'une quelconque des revendications 1 à 9, **caractérisé en ce que** l'écart entre la tension de l'électrode de préparation de champ et la tension de l'électrode d'extinction de champ peut être réglé de manière variable.

11. Agencement de circuit selon au moins l'une quelconque des revendications 1 à 10, **caractérisé en ce que** le dispositif à électrode de séparation s'étend en forme de traverse entre l'électrode de préparation de champ et l'électrode d'extinction de champ.
